# EUROPEAN PATENT APPLICATION

(11) **EP 4 766 044 A1**
(43) Date of publication of application: **24.06.2026**
(21) Application number: 25203899.7
(22) Date of filing: 23.09.2025
(51) Int. Cl.: H05K 7/14, H02M 7/00, H05K 7/20

(54) **INVERTER AND ENERGY STORAGE SYSTEM INCLUDING THE SAME**

(30) Priority: 18.12.2024 KR 20240190087
(71) Applicant: Hanwha Solutions Corporation, Jung-gu Seoul 04541 (KR)
(72) Inventor: CHOI, You Chang, 04541 Seoul (KR); PARK, Je Hyun, 04541 Seoul (KR)
(74) Representative: Mooser, Sebastian Thomas

(57) **Abstract**

Provided is an inverter including a main case, a heat dissipation case that covers one side of the main case and has a plurality of heat dissipation fins, and a circuit board unit arranged in an internal space defined by an assembly of the main case and the heat dissipation case, the circuit board unit having at least one circuit board configured to mutually convert between direct current power and alternating current power, wherein the heat dissipation case includes a support block protruding toward the internal space and on which the circuit board is arranged.

## Description

### BACKGROUND

### 1. Field

The present disclosure relates to an inverter and an energy storage system including the same.

### 2. Description of the Related Art

In general, an inverter is a device that converts direct current (DC) electricity generated by an electrical energy generation device, such as a solar module, into alternating current (AC) electricity, and stores electrical energy in a battery serving as a power storage device, and may also supply AC electricity to home appliances that consume AC electricity, and a power grid, and maintain power quality by adjusting an output voltage and frequency.

An inverter may be used as a standalone unit connected to a solar panel, a power grid, and the like, but may also be integrated with other external devices, such as an energy storage system (ESS), to serve as an all-in-one solution. This configuration may improve the efficiency of power conversion and storage.

### SUMMARY

The present disclosure provides an inverter capable of effectively dissipating internal heat, and an energy storage system including the inverter.

Additional aspects will be set forth in part in the description which follows and, in part, will be apparent from the description, or may be learned by practice of the presented embodiments of the disclosure.

An embodiment of the present disclosure may provide an inverter including: a main case; a heat dissipation case that covers one side of the main case and has a plurality of heat dissipation fins; and a circuit board unit arranged in an internal space defined by an assembly of the main case and the heat dissipation case, the circuit board unit having at least one circuit board configured to mutually convert between direct current power and alternating current power, wherein the heat dissipation case includes a support block protruding toward the internal space and on which the circuit board is arranged.

In an embodiment, the inverter may further include a thermally conductive pad arranged between the support block and the circuit board.

In an embodiment, the thermally conductive pad may have an elastic restoring force.

In an embodiment, the thermally conductive pad may have a height that is less than a height of the support block.

In an embodiment, the inverter may further include a heating element arranged below the circuit board, and the thermally conductive pad may be arranged between the heating element and the support block.

In an embodiment, the thermally conductive pad may be in contact with the support block, and a total area of the thermally conductive pad may be greater than a contact area between the thermally conductive pad and the support block.

In an embodiment, the heat dissipation case may further include a support protrusion extending toward the circuit board and supporting the circuit board.

In an embodiment, the support protrusion may include a plurality of support protrusions arranged along a circumference of the support block.

In an embodiment, the support block may be arranged on a side of the heat dissipation case opposite to the side on which the heat dissipation fin is arranged.

In an embodiment, the support block may space the circuit board apart from an inner surface of the heat dissipation case by a preset interval.

In addition, another embodiment of the present disclosure may provide an energy storage system including: an inverter; and a storage device, wherein the inverter includes: a main case; a heat dissipation case that covers one side of the main case and has a plurality of heat dissipation fins; and a circuit board unit arranged in an internal space defined by an assembly of the main case and the heat dissipation case, the circuit board unit having at least one circuit board configured to mutually convert between direct current power and alternating current power, the heat dissipation case includes a support block protruding toward the internal space and on which the circuit board is arranged, and the inverter and the storage device are electrically connected to each other.

In an embodiment, the energy storage system may further include a thermally conductive pad arranged between the support block and the circuit board.

In an embodiment, the energy storage system may further include a heating element arranged below the circuit board, and the thermally conductive pad may be arranged between the heating element and the support block.

In an embodiment, the heat dissipation case may further include a support protrusion extending toward the circuit board and supporting the circuit board.

In an embodiment, the support block may be arranged on a side of the heat dissipation case opposite to the side on which the heat dissipation fin is arranged.

Other aspects, features, advantages other than those described above will become apparent from the following drawings, claims, and detailed description of the present disclosure.

### BRIEF DESCRIPTION OF THE DRAWINGS

The above and other aspects, features, and advantages of certain embodiments of the disclosure will be more apparent from the following description taken in conjunction with the accompanying drawings in which:
FIG. 1 is a block diagram schematically illustrating an energy storage and distribution system according to an embodiment of the present disclosure;
FIG. 2 is a block diagram schematically illustrating an energy storage system and a controller, according to an embodiment of the present disclosure;
FIG. 3 is a diagram illustrating coupling between an inverter and a storage device, according to an embodiment of the present disclosure;
FIG. 4 is an exploded perspective view of the inverter of FIG. 3;
FIG. 5 is an exploded perspective view of some components of FIG. 3;
FIG. 6 is a rear view of an inverter according to an embodiment of the present disclosure;
FIG. 7 is a cross-sectional view taken along line III-III' of FIG. 3;
FIG. 8 is a cross-sectional view taken along line IV-IV' of FIG. 3; and
FIG. 9 is an enlarged view of portion A of FIG. 8.

### DETAILED DESCRIPTION

Reference will now be made in detail to embodiments, examples of which are illustrated in the accompanying drawings, wherein like reference numerals refer to like elements throughout. In this regard, the present embodiments may have different forms and should not be construed as being limited to the descriptions set forth herein. Accordingly, the embodiments are merely described below, by referring to the figures, to explain aspects.

As the present disclosure allows for various changes and numerous embodiments, particular embodiments will be illustrated in the drawings and described in detail. Advantages and features of the present disclosure and a method of achieving the same should become clear with embodiments described below in detail with reference to the drawings. However, the present disclosure is not limited to the embodiments disclosed below, but may be implemented in various forms.

Hereinafter, embodiments of the present disclosure will be described in detail with reference to the accompanying drawings, and the same or corresponding components will be denoted by the same reference numerals when described with reference to the accompanying drawings, and thus, their descriptions that are already provided will be omitted.

In the following embodiments, terms such as "first," "second," etc., are used only to distinguish one component from another, and such components must not be limited by these terms.

In the following embodiments, the singular expression also includes the plural meaning as long as it is not inconsistent with the context.

In the following embodiments, the terms "comprise," "include," "have," and the like used herein specify the presence of stated features or components, but do not preclude the presence or addition of one or more other features or components.

In the following embodiments, when an element such as a layer, region, or component is referred to as being "on," "in front of," "behind," or "under" another element, it may encompass cases where the elements are in direct contact, as well as cases where intervening elements may be present.

For convenience of descriptions, the magnitude of components in the drawings may be exaggerated or reduced. For example, the size and thickness of each element illustrated in the drawings are provided arbitrarily for convenience of descriptions, and thus, the present disclosure is not necessarily limited to those illustrated in the drawings.

In addition, it should be understood that some elements may be omitted, only a part of an element may be illustrated, or an element may be schematically represented in the drawings for the purpose of simplification, or when deemed sufficient or necessary for the description.

In the following embodiments, when an element is referred to as being "connected" to another element, this may include both cases where they are directly connected and cases where they are indirectly connected with other elements therebetween.

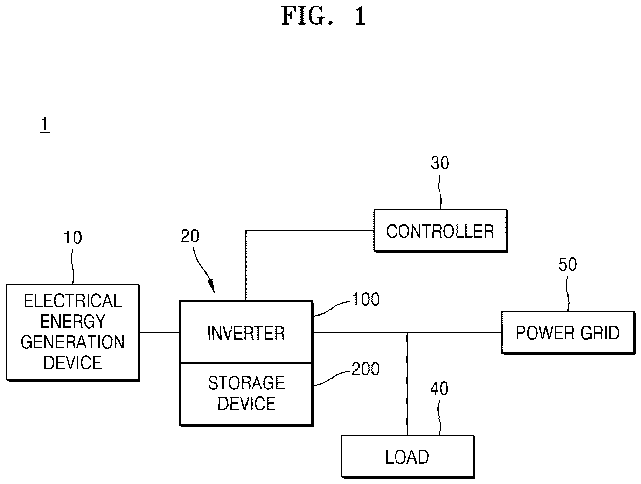

FIG. 1 is a block diagram schematically illustrating an energy storage and distribution system according to an embodiment of the present disclosure.

Referring to FIG. 1, an energy storage and distribution system 1 may convert direct current (DC) electricity generated from an electrical energy generation device 10 such as a solar module, into alternating current (AC) electricity, and supply the AC electricity to a load 40, a power grid 50, and the like, or may store power generated from the electrical energy generation device 10 in a storage device 200, and then convert and supply the stored power as needed.

The electrical energy generation device 10 refers to a device that generates electrical energy by converting various forms of energy, and may generate electrical energy in various ways depending on the type of energy source.

For example, the electrical energy generation device 10 may be a solar module that converts sunlight into electrical energy by using a solar panel. However, the present disclosure is not limited thereto, and the electrical energy generation device 10 may be provided as various devices, such as a wind power generation device or a hydroelectric power generation device.

An energy storage system 20 stores electricity generated from the electrical energy generation device 10, such as a solar module, and converts the stored DC electricity into AC electricity to supply the AC electricity to an external destination, and may include an inverter 100 and the storage device 200.

The inverter 100 may be connected to or integrated with the storage device 200. Accordingly, DC electricity generated from the electrical energy generation device 10 may be stored in the storage device 200 and then converted into AC electricity by the inverter 100 to be supplied to the load 40, the power grid 50, and the like, as needed.

However, the present disclosure is not limited thereto, and within the technical scope of being able to mutually convert between DC electricity and AC electricity from an external source, the inverter 100 may be connected to or integrated with various components of the energy storage and distribution system, such as a converter, a battery management system (BMS), or a power management system.

A controller 30 is electrically connected to the energy storage system 20, and may receive operation data from the energy storage system 20 to monitor its operational status and control its operating conditions.

In some embodiments, the controller 30 may check the operational status of the inverter 100 in real time. In some embodiments, the controller 30 may receive, from the inverter 100, information about various parameters of the electrical energy generation device 10, such as the total amount of power generation or the AC voltage. In some embodiments, when a defect or failure occurs during the operation of the inverter 100, the controller 30 may generate an alarm to notify a user.

The load 40 is a general term referring to any device that consumes electricity, and examples of the load 40 may include household electrical appliances, heating and cooling systems, lighting and equipment in commercial facilities, and machinery in industrial sites. In general, because the load 40 uses AC electricity, DC electricity introduced to charge the storage device 200 is converted into AC electricity by the inverter 100 and then supplied to the load 40.

The power grid 50 may be defined as a power network that transmits and distributes AC electricity, which has been converted by the inverter 100, to supply the AC electricity to consumers. The power grid 50 may be connected to an electrical distribution network of a house or building to distribute electrical energy supplied from the electrical energy generation device 10 or the energy storage system 20.

The energy storage and distribution system 1 according to an embodiment of the present disclosure may be a power network where electrical energy generated from the electrical energy generation device 10 enters the energy storage system 20 to be stored in the storage device 200, or the stored electrical energy is converted and supplied to the load 40 and the power grid 50 to be ultimately delivered to consumers.

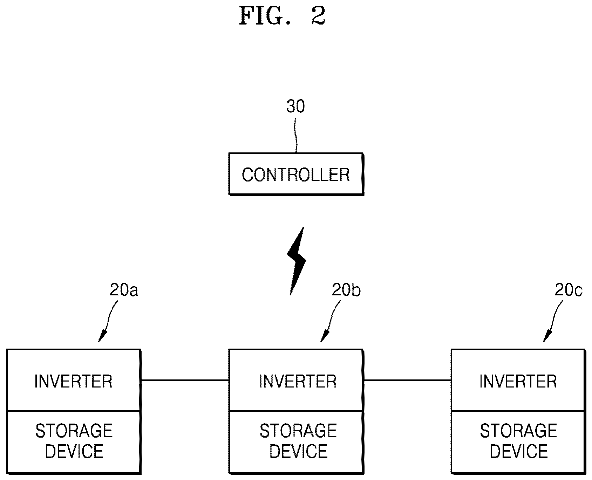

FIG. 2 is a block diagram schematically illustrating an energy storage system and a controller, according to an embodiment of the present disclosure.

Referring to FIG. 2, a plurality of energy storage systems 20 may be provided and connected to each other. The number of energy storage systems 20 is not limited to a specific number and may be variously configured depending on the installation location of the energy storage systems 20, or the like. However, for convenience of descriptions, the following description will focus on an embodiment in which three energy storage systems 20a, 20b, and 20c are connected to a controller.

In an embodiment, the energy storage systems may include a first energy storage system 20a, a second energy storage system 20b, and a third energy storage system 20c, which may be electrically connected to each other. For example, the first energy storage system 20a, the second energy storage system 20b, and the third energy storage system 20c may be connected to each other by cables to transmit electrical signals or to allow current to flow between them.

The controller 30 according to an embodiment of the present disclosure may be connected to the first energy storage system 20a, the second energy storage system 20b, and the third energy storage system 20c via wired or wireless communication.

In a case in which the controller 30 is connected via a wired connection to the first energy storage system 20a, the second energy storage system 20b, and the third energy storage system 20c, the controller 30 may be connected to a storage device of any one of the first energy storage system 20a, the second energy storage system 20b, and the third energy storage system 20c, and may receive operation data from the other storage devices.

In another embodiment, the controller 30 may be connected to each of the first energy storage system 20a, the second energy storage system 20b, and the third energy storage system 20c to receive their respective operation data.

In some embodiments, the controller 30 may be wirelessly connected to the energy storage system 20 to receive operation data via wireless communication.

As the controller 30 monitors information about the energy storage system 20 in real time and adjusts operating conditions, it is possible to immediately respond to a problem occurring during an operation, and a power consumption or the like is output in real time such that processes of generating, storing, and distributing electrical energy are performed more efficiently.

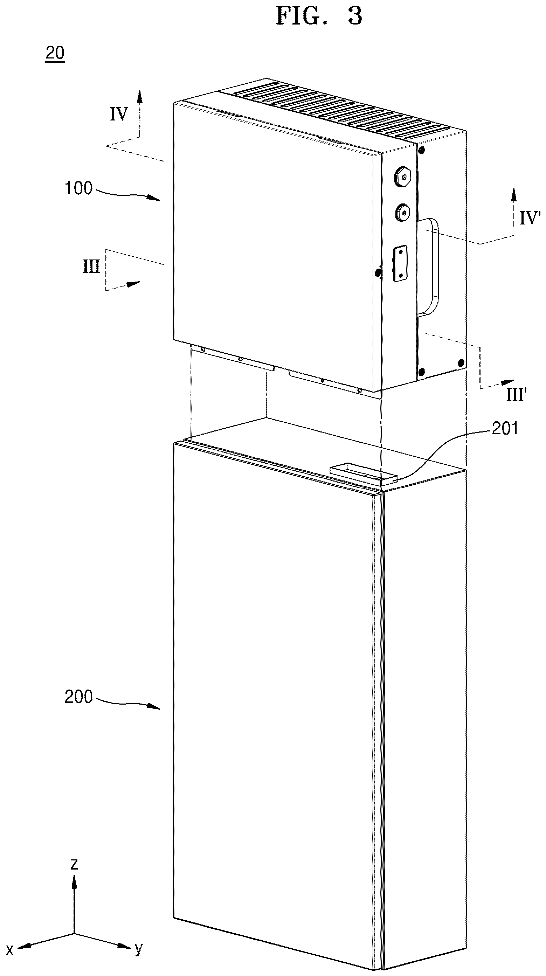

FIG. 3 is a diagram illustrating coupling between an inverter and a storage device, according to an embodiment of the present disclosure.

Referring to FIG. 3, the energy storage system 20 according to an embodiment of the present disclosure may include the inverter 100 and the storage device 200.

The inverter 100 and the storage device 200 may be electrically connected to each other via a DC connector or AC connector (not shown), and accordingly, the inverter 100 may receive DC electricity or convert the received DC electricity into AC electricity to transmit the AC electricity to an external destination.

In other words, the inverter 100 may be electrically connected to the storage device 200 to supply power to the storage device 200, or receive power from the storage device 200 to output the power to an external destination.

The inverter 100 may be coupled to the storage device 200 in a vertical direction. In the present specification, the term "vertical direction" may refer to a z-axis direction, an up-down direction in FIG. 3, and a lengthwise direction of the storage device 200.

The storage device 200 may be a power storage device for storing electrical energy supplied from an external electrical energy generation device 10. Thus, although the present specification describes an example in which the storage device 200 is a power storage device, the present disclosure is not limited thereto, and various modifications may be made to other external devices within the technical scope, provided that they may be electrically connected to the inverter 100 capable of mutually converting between DC and AC power.

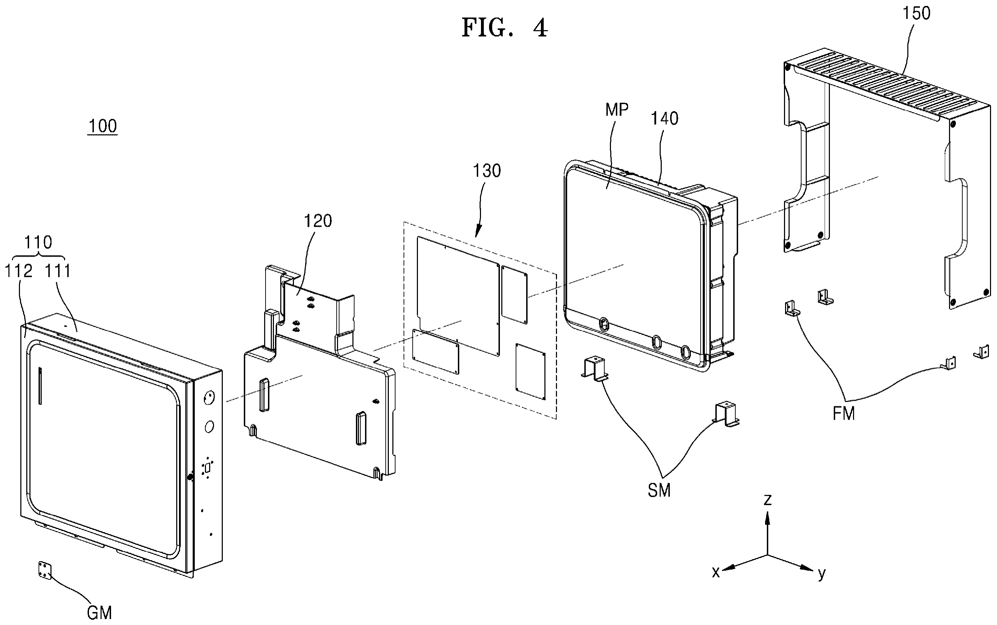

FIG. 4 is an exploded perspective view of the inverter of FIG. 3.

Referring to FIG. 4, the inverter 100 is capable of mutually converting between DC electricity and AC electricity supplied from an external source, and may include a main case 110, a safety cover 120, a circuit board unit 130, a heat dissipation case 140, and a hood cover 150.

The main case 110, the safety cover 120, the circuit board unit 130, and the heat dissipation case 140 may be coupled to each other in a first direction. In the present specification, the term "first direction" may refer to an x-axis direction, and the term "second direction" may refer to a y-axis direction.

The main case 110 may be connected to the storage device 200 through a fixing member GM. The heat dissipation case 140, which covers one side of the main case 110 and has a plurality of heat dissipation fins 143, defines an internal space in which the circuit board unit 130 may be arranged.

In the present specification, the term "internal space" may refer to a space that is defined by the assembly of the main case 110 and the heat dissipation case 140. In other words, the internal space may refer to a space enclosed by the main case 110 and the heat dissipation case 140.

The main case 110 may include a main body 111 that forms the internal space, and a door 112 that is rotatably connected to the main body 111 and covers an open area of the main body 111.

The door 112 may be closed during normal operation to maintain a sealed state of the internal space. However, when connecting the inverter 100 to another component, or when it is necessary to install or replace a part arranged inside the inverter 100, an operator may perform a required task by rotating and opening or detaching the door 112.

The safety cover 120 that covers the circuit board unit 130 may be installed in the internal space. The safety cover 120 is arranged on one side of the circuit board unit 130 to protect a plurality of circuit boards from an external environment, and may prevent the circuit boards from being exposed to the external environment when the door 112 is opened, and may reduce the possibility of failure and malfunction of the inverter 100.

In some embodiments, the safety cover 120 may physically separate components through which current flows, from a worker, thereby preventing electric shock accidents and enhancing the safety of the working environment.

The circuit board unit 130 may be arranged in the internal space and may have at least one circuit board capable of mutually converting between DC power and AC power.

In an embodiment, the circuit board unit 130 may include a first board, a second board, a third board, and a fourth board, which are configured as circuit boards. The first board, the second board, the third board, and the fourth board may be referred to as "circuit boards" or "a plurality of circuit boards".

Each circuit board may be provided as a filter board, a main board, a battery management and protection system (BMPS) board, a switching-mode power supply (SMPS) board, or the like, and may include power semiconductors such as metal-oxide-semiconductor field-effect transistors (MOSFETs) or insulated-gate bipolar transistors (IGBTs), control circuits, sensors, a printed circuit boards, and the like. Here, the respective circuit boards may be stacked and arranged within the internal space, or may be arranged to be spaced apart from each other on the same plane.

A main plate MP may be arranged between the safety cover 120 and the heat dissipation case 140. The main plate MP, which supports at least one circuit board of the circuit board unit 130, may partition the internal space.

The plurality of circuit boards may be arranged on opposite sides of the main plate MP. In other words, the circuit boards may be arranged in the multiple spaces that are partitioned by the main plate MP. Thus, although not shown in the drawings, the circuit boards may be arranged not only in the space between the safety cover 120 and the main plate MP but also in the space between the main plate MP and the heat dissipation case 140.

Accordingly, the plurality of circuit boards included in the circuit board unit 130 may be stacked and arranged in the first direction within the internal space of the inverter 100 for an energy storage system.

The safety cover 120 may be fastened and fixed to the main plate MP. In other words, the safety cover 120 may be fixed in place on the main plate MP while covering a portion of the circuit board unit.

The main plate MP may be pre-assembled with a plurality of coupling members (not shown), which support the safety cover 120 and connect the main plate MP to the safety cover 120.

In an embodiment, the coupling member may be provided as a supporter that may fix the safety cover 120 in position on the main plate MP and evenly distribute the load of the safety cover 120 to provide a stable support structure. In an embodiment, the coupling member may be provided as a standoff that is designed to maintain a preset interval between the safety cover 120 and the main plate MP.

The heat dissipation case 140 may be formed to protrude in the first direction. As the heat dissipation case 140 is formed to protrude outward, an inner side of the protruding area is concavely formed, thereby providing an internal space.

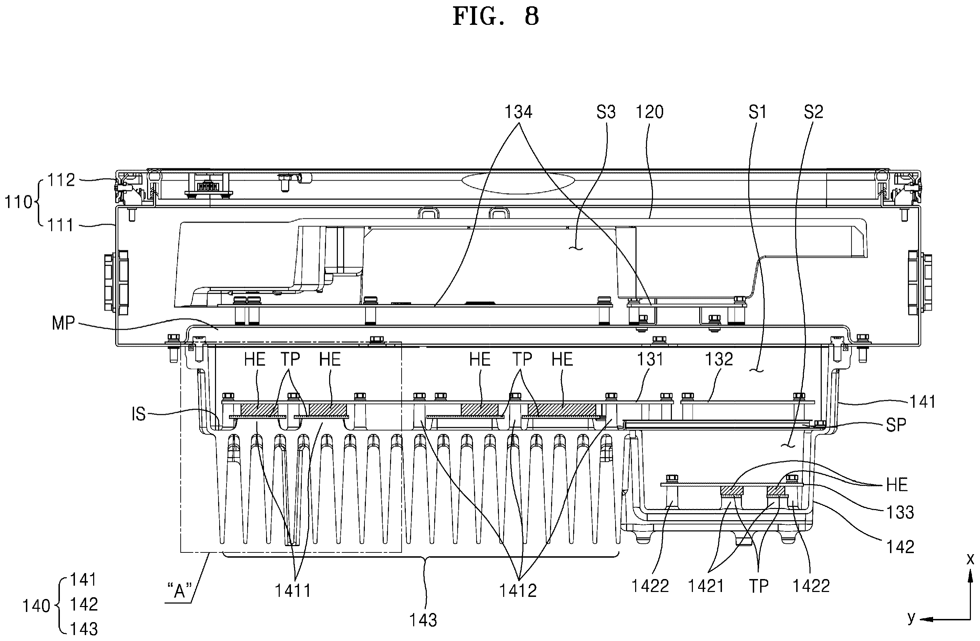

Referring to FIG. 8, at least one circuit board may be accommodated in the space enclosed by the heat dissipation case 140 and the main plate MP. Accordingly, the plurality of circuit boards included in the circuit board unit 130 may be completely enclosed by the main case 110, the safety cover 120, and the heat dissipation case 140.

The heat dissipation case 140 may efficiently dissipate heat within the internal space, which is generated from the circuit board unit 130, to the outside. Accordingly, the heat dissipation case 140 may prevent excessive heat from accumulating inside the inverter 100 to cause performance degradation of the circuit boards or defects during operation.

The hood cover 150 surrounds the heat dissipation case 140 and connects to the main case 110, and may be arranged to cover the side and upper surfaces of the heat dissipation case 140, thereby protecting the heat dissipation case 140 from the outside.

In some embodiments, the hood cover 150 may physically block a user or worker from contacting the surface of the heat dissipation case 140, which reaches a high temperature due to heat generated from the internal circuit boards, thereby protecting the user and worker.

A lower portion of the hood cover 150 may be connected to the upper surface of the storage device 200. In some embodiments, areas corresponding to the corners of the lower portion of the hood cover 150 may be fastened to the storage device 200 by fastening members FM, respectively. Accordingly, the inverter 100 may be securely fixed on the storage device 200.

The fastening member FM is fastened to the hood cover 150 and may connect the hood cover 150 to the storage device 200.

A plurality of fastening members FM may be provided. Some of the plurality of fastening members FM may be fixed by welding to a rear surface part of a main body 111, to fix the four corners of the hood cover 150 to the main case 110, and more specifically, to the main body 111.

In some embodiments, others of the plurality of fastening members FM may be fixed by welding onto the storage device 200, to fix opposite lower end portions (the lower side in FIG. 4) of the hood cover 150 to the storage device 200.

Because the main case 110 is connected to the hood cover 150 by the fastening members FM, and the hood cover 150 is connected to the storage device 200, the main case 110 may be indirectly fixed to the storage device 200.

The inverter 100 may further include the fixing member GM and support members SM.

The fixing member GM, which connects the main case 110 to the storage device 200, may be formed to extend in a vertical direction, such that one side thereof may be connected to the main case 110, and the other side thereof may be connected to the storage device 200.

Accordingly, the fixing member GM may maintain the fixation between the main body 111 and a front part (the left side in FIG. 4) of the storage device 200, even when the door 112 is opened or detached.

In some embodiments, the fixing member GM may provide guidance when the inverter 100 and the storage device 200 are connected to each other, such that each component may be aligned with a common centerline in a vertical direction.

The support member SM is arranged between the heat dissipation case 140 and the storage device 200, and one surface of the support member SM may contact the storage device 200, and the opposite surface may contact the heat dissipation case 140.

Accordingly, the support members SM may stably support a lower portion of the heat dissipation case 140 that protrudes in the first direction, and may cause the heat dissipation case 140 and the storage device 200 to be spaced apart from each other by a preset interval. A plurality of support members SM may be provided, and the plurality of support members SM may be respectively arranged on opposite sides of the heat dissipation case 140 to distribute the weight of the heat dissipation case 140 and thereby provide more stable support.

The upper surface (the upper side in FIG. 4) of the support member SM may undergo a masking treatment to serve as a ground connection between the heat dissipation case 140 and the storage device 200. Accordingly, the support members SM may physically support the inverter 100 and simultaneously improve the electrical stability of the entire energy storage system 20.

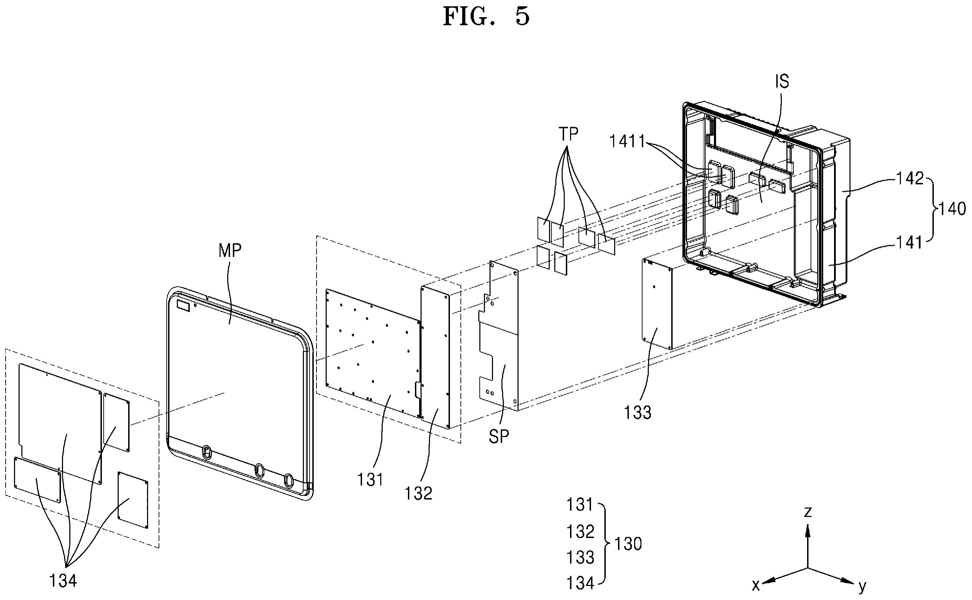

FIG. 5 is an exploded perspective view of some components of FIG. 3.

Referring to FIG. 5, the main plate MP, a sub-plate SP, and the circuit board unit 130 may be arranged in an internal space between the main case 110 and the heat dissipation case 140.

The heat dissipation case 140, which covers the main case 110 and has an internal space, may include a first body 141 connected to the main case 110, and a second body 142 extending from the first body 141 and arranged adjacent to the heat dissipation fins 143.

The second body 142 may be formed to protrude outward from the first body 141 and thus have an internal space. In other words, the second body 142 and the heat dissipation fins 143 may be arranged on a rear surface (the left side in FIG. 5) of the first body 141.

The main plate MP, which is arranged between the main case 110 and the heat dissipation case 140 and supports a circuit board, may separate the internal space that is defined by the main case 110 and the heat dissipation case 140.

The sub-plate SP, which is arranged inside the heat dissipation case 140, may separate an internal space enclosed by the main plate MP, the first body 141, and the second body 142. Accordingly, the internal space enclosed by the main case 110 and the heat dissipation case 140 may be separated into a total of three spaces by the main plate MP and the sub-plate SP.

In the present specification, for convenience of descriptions, in the internal space, the space within the heat dissipation case 140 that is enclosed by the main plate MP and the first body 141 is defined as a first space S1, and the space enclosed by the sub-plate SP and the second body 142 is defined as a second space S2. Furthermore, the space enclosed by the main case 110 and the main plate MP is defined as a third space S3.

The circuit board unit 130, which is arranged in the internal space and has a plurality of circuit boards, may include a first board 131, a second board 132, a third board 133, and a fourth board 134. The plurality of circuit boards may be arranged in the internal space.

In some embodiments, the first board 131 and the second board 132 may be arranged in the first space S1, which is located on an inner side of the first body 141, the third board 133 may be arranged in the second space S2, and the fourth board 134 may be arranged in the third space S3.

The heat dissipation case 140 may have support blocks 1411 that protrude toward the internal space, and on which a circuit board is arranged.

In the present specification, a surface of the heat dissipation case 140 on which the support blocks 1411 are arranged is defined as an inner surface IS.

The support blocks 1411 may protrude from the inner surface IS, and a plurality of support blocks 1411 may be arranged on the heat dissipation case 140. Here, the circuit board unit 130 may be supported by the plurality of support blocks 1411, and may be arranged to be spaced apart from the inner surface IS by a preset interval.

Thermally conductive pads TP, which are arranged between the support block 1411 and a circuit board, may directly transfer heat generated from the circuit board to the heat dissipation case 140.

The thermally conductive pads TP according to an embodiment of the present disclosure may be arranged on the plurality of support blocks 1411, respectively.

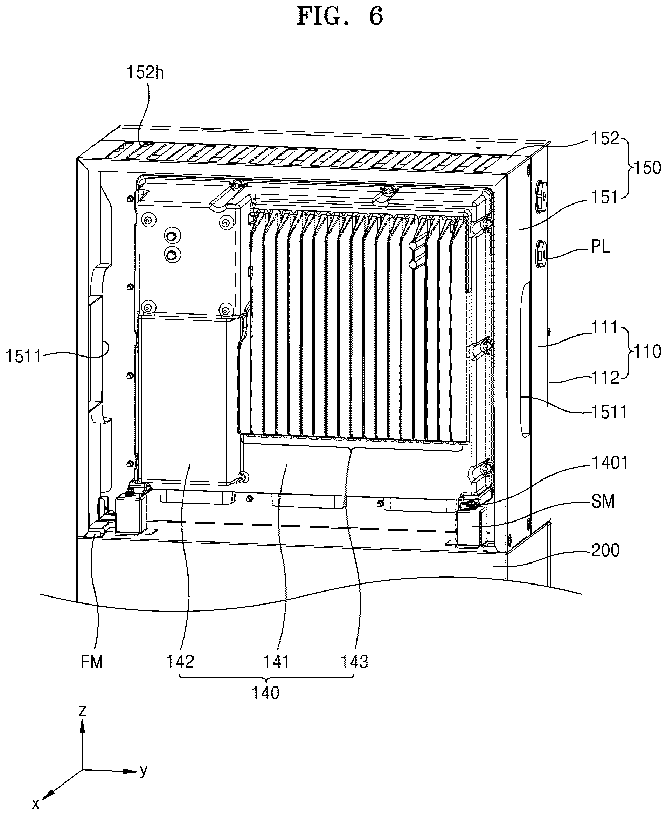

FIG. 6 is a rear view of an inverter according to an embodiment of the present disclosure.

Referring to FIG. 6, the heat dissipation case 140, which covers one side of the main case 110 and has a plurality of heat dissipation fins 143, may include the first body 141, the second body 142, and the plurality of heat dissipation fins 143.

The first body 141 is connected to the main case 110 and accommodates at least one circuit board, and the heat dissipation fins 143 may be formed on a surface of the first body 141 that is opposite to the surface on which the circuit board is arranged. In some embodiments, the circuit board unit 130 may be arranged on the inner surface IS of the first body 141, which forms the internal space, and the heat dissipation fins 143 may be formed on the surface opposite to the inner surface IS to protrude outward.

Accordingly, heat generated from the circuit boards arranged in the internal space may be transferred through the first body 141 to the heat dissipation fins 143 and dissipated to the outside.

The second body 142, which is arranged adjacent to the heat dissipation fins 143 and has an internal space, may be formed to protrude from the first body 141 in the first direction. As the second body 142 protrudes outward, a space in which a circuit board may be additionally accommodated may be formed inside the second body 142.

Accordingly, inside the inverter 100 according to an embodiment of the present disclosure, a plurality of circuit boards that constitute the circuit board unit 130 may be stacked to be supported by the main plate MP, the first body 141, and the second body 142.

A plurality of heat dissipation fins 143 may be provided and arranged on a surface of the heat dissipation case 140 to protrude outward.

The heat dissipation fin 143 may extend in a vertical direction and may have a long, thin shape. The plurality of the heat dissipation fins 143 may be arranged on the heat dissipation case 140 to be spaced apart from each other by a preset interval. Due to such an optimized structure of the heat dissipation fins 143, the surface area of the heat dissipation case 140 may be maximized, and the heat dissipation efficiency may be increased.

The heat dissipation fins 143 may include various materials, for example, a metallic material with high thermal conductivity, such as aluminum or copper. However, the present disclosure is not limited thereto, and various modifications to the material are possible within the technical scope, provided that the material has high thermal conductivity and is capable of efficiently dissipating heat from the inside of the heat dissipation case 140.

Referring to FIG. 6, connection protrusions 1401, which each have a surface that faces the storage device 200, and are formed to protrude from a lower portion (in FIG. 6) of the heat dissipation case 140, may be connected to the support members SM.

In some embodiments, the connection protrusions 1401 may be arranged parallel to a surface (the upper surface in FIG. 6) of the storage device 200 on which the inverter 100 is seated. The support member SM may be arranged between the connection protrusion 1401 and the storage device 200, which are arranged parallel to each other. One end of the support member SM may be connected to the storage device 200, and another end of the support member SM may be connected to the connection protrusion 1401.

The heat dissipation case 140 may be connected to the support members SM through the connection protrusions 1401 to be stably fixed on the storage device 200.

The connection protrusions 1401 may be symmetrically arranged on opposite sides of the heat dissipation case 140, and a plurality of support members SM may be provided to be connected to the connection protrusions 1401 so as to support the opposite sides of the heat dissipation case 140.

In a case in which the connection protrusions 1401 are arranged on opposite sides of the heat dissipation case 140 such that the opposite sides of the heat dissipation case 140 are supported, the load of the heat dissipation case 140 and the circuit board unit 130 accommodated therein may be distributed to the opposite sides, and the risk of deformation or damage due to the load of the heat dissipation case 140 may be reduced.

Furthermore, resistance to external forces and vibration is increased, and thus, balance may be stably maintained.

The hood cover 150, which surrounds the heat dissipation case 140 and is connected to the main case 110, may protect the heat dissipation case 140 from external impacts. The hood cover 150 may include a side cover 151 and a connection cover 152.

The side cover 151 extends along a side surface of the heat dissipation case 140, and a pair of the side covers 151 may be provided on opposite side surfaces of the heat dissipation case 140.

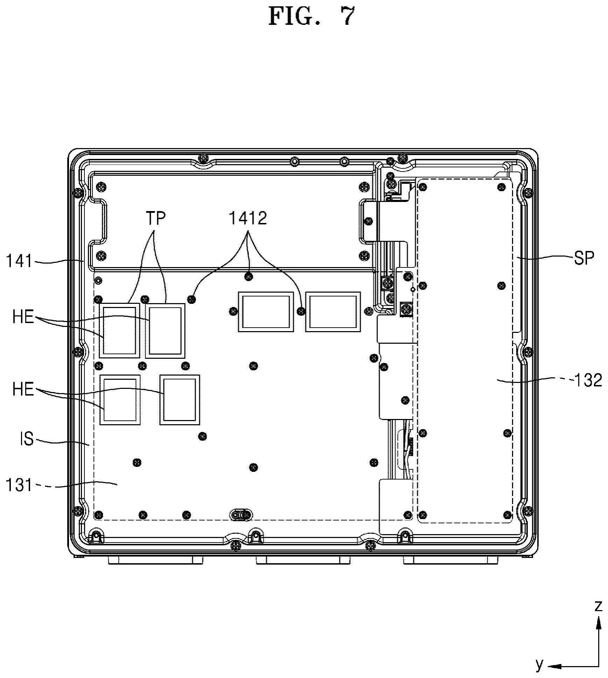

In other words, the side covers 151 may extend in a vertical direction from opposite side surfaces of the heat dissipation case 140, respectively. Lower end portions (lower portion in FIG. 7) of the pair of side covers 151 may each be fastened to the storage device 200.

In this case, one end portion of one side cover 151 may be fastened to a fastening member FM, which is welded to the main case 110, to be connected to the main case 110, and the opposite end portion may be fastened to another fastening member FM, which is welded to the storage device 200, to be connected to the storage device 200.

A handle 1511 may be formed along one side of the side cover 151. The handle 1511 has a structure in which one surface of the side cover 151 is recessed in the first direction, and may be formed by machining one surface of the side cover 151.

The handle 1511 may be formed in each of the pair of side covers 151. The pair of handles 1511 are formed in a symmetrical structure, such that an operator may easily grip the hood cover 150 when installing and detaching the inverter 100.

The hood cover 150 may include the connection cover 152 that connects the pair of side covers 151 to each other. The connection cover 152 is arranged between the side covers 151 and may extend in the second direction.

The hood cover 150 may have a plurality of cover holes 152h that serve as passages between the interior and the exterior and extend in the first direction.

The plurality of cover holes 152h may be arranged on the connection cover 152 and may be spaced apart from each other by a preset interval on the connection cover 152. In some embodiments, the plurality of cover holes 152h may be arranged to be spaced apart from each other in the second direction, which is the lengthwise direction of the connection cover 152.

The cover holes 152h may be passages through which heat discharged from the heat dissipation fins 143 escapes. Because the plurality of heat dissipation fins 143 and the plurality of cover holes 152h are all arranged to be spaced apart from each other in the second direction, heat discharged through the heat dissipation fins 143 may be easily discharged to the outside through the cover holes 152h.

Furthermore, the cover holes 152h, which serve as passages between the interior and exterior of the hood cover 150, may facilitate air circulation between an inner side and an outer side of the inverter 100 to prevent heat from accumulating in a specific area.

The fastening member FM, which has a bent shape and is fastened to the hood cover 150, may connect the hood cover 150 to the storage device 200.

A plurality of fastening members FM may be provided. Some of the plurality of fastening members FM may be welded to a rear surface portion of the main body 111 to fix the hood cover 150 to the main body 111.

In some embodiments, a total of four fastening members FM may be welded to a rear surface portion of the main body 111. The four fastening members FM may form two pairs, and the pairs may be arranged in an upper portion (not shown) and a lower portion (the lower side in FIG. 6) of the main body 111, respectively.

In this case, a bent end and another end of each of the two fastening members FM arranged in the lower portion of the main body 111 may be connected to the hood cover 150 and the storage device 200, respectively. In some embodiments, a surface connecting the bent end to the other end may be welded to a rear surface portion of the main body 111.

In some embodiments, some of the plurality of fastening members FM may each have one end welded to the storage device 200 and another end fastened to opposite lower ends (the lower side in FIG. 6) of the hood cover 150, to fix the hood cover 150 to the storage device 200.

That is, because the main case 110 is connected to the hood cover 150 by the fastening members FM, and the hood cover 150 is connected to the storage device 200, the main case 110 may be indirectly fixed to the storage device 200.

FIG. 7 is a cross-sectional view taken along line III-III' of FIG. 3.

Referring to FIG. 7, a plurality of circuit boards may be arranged in the first body 141. In some embodiments, the first board 131 and the second board 132 may be arranged in the first body 141.

The first board 131 may be arranged on the inner surface IS of the heat dissipation case 140 and supported by the support blocks 1411, and the second board 132 may be directly supported by the sub-plate SP.

The first board 131 may be a main board of the inverter 100, which is capable of mutually converting between DC power and AC power, and the second board 132 may be a filter board that selectively passes a signal in a specific frequency band or removes noise included in an electrical signal so as to improve device performance. However, the type of each circuit board is not limited thereto, and a circuit board having another function may be provided as necessary.

The support block 1411, which protrudes into the internal space and on which a circuit board is arranged, may be provided in the shape of a pillar having a preset cross-sectional area. A plurality of support blocks 1411 may be provided on the inner surface IS of the first body 141, and may be arranged to be spaced apart from each other.

The thermally conductive pad TP may be arranged on an upper surface of the support block 1411. In other words, the support block 1411 may be connected to the inner surface IS of the first body 141, and an opposite side thereof may be connected to the thermally conductive pad TP.

The thermally conductive pad TP, which is arranged between the support block 1411 and a circuit board, may minimize an air gap between the support block 1411 and the circuit board and fill in surface irregularities between the respective components to maximize thermal conduction efficiency.

The thermally conductive pad TP may have an elastic restoring force. In some embodiments, the thermally conductive pad TP may be manufactured by mixing thermally conductive particles, such as metal oxides or nitrides, with an insulating material, such as silicone or a polymer, and may be formed to have flexibility.

In general, the surface of a circuit board is often not perfectly smooth, and accordingly, a microscopic gap may occur between the circuit board and the heat dissipation case 140. In this case, the thermally conductive pad TP, which has an elastic restoring force and flexibility, may be in close contact with an irregular surface to remove an air layer between microscopic gaps and maximize heat transfer efficiency.

Furthermore, although the gap between each support block 1411 and a circuit board may be inconsistent during design and assembly processes of the inverter 100, the thermally conductive pad TP according to an embodiment of the present disclosure has an elastic restoring force such that its thickness is adjusted upon pressure applied thereto, to fill the gap between the support block 1411 and the circuit board and stably maintain a heat transfer path.

The thermally conductive pad TP may be arranged to be in contact with the support block 1411, and may be provided to have a cross-sectional area that is greater than that of the support block 1411. In other words, the total area of the thermally conductive pad TP may be relatively greater than the contact area with the support block 1411.

Accordingly, although the first board 131 is supported by the support blocks 1411, it may not directly contact the support blocks 1411, and thus, an electrical short circuit between the circuit board and the heat dissipation case 140 may be prevented.

Heating elements HE may be further arranged on the first board 131. In some embodiments, the heating elements HE may be arranged below the first board 131 to face the thermally conductive pads TP. The heating element HE may refer to any component that is arranged on a circuit board and generates heat as current flows therethrough. For example, the heating elements HE may include power devices such as transistors or diodes, resistors, coils, transformers, integrated circuits, and the like.

The heating element HE may be arranged on the support block 1411, and the thermally conductive pad TP may be arranged between the heating element HE and the support block 1411. Accordingly, heat generated by the heating elements HE may be quickly discharged to the outside of the heat dissipation case 140 through the thermally conductive pads TP and the support blocks 1411.

In other words, the support blocks 1411 may be provided at positions respectively corresponding to the positions of the heating elements HE arranged on the circuit board. Accordingly, the heating elements HE may be arranged on a surface of the circuit board that is supported by the support blocks 1411.

The heat dissipation case 140 may have support protrusions 1412 that extend toward the circuit board and support the circuit board. The support protrusion 1412 may connect the circuit board to the heat dissipation case 140, may be formed in a cylindrical shape, and may have formed therein a screw thread to allow a fastening element, such as a screw, to be inserted. In an alternative embodiment, the support protrusion 1412 may have a boss shape.

When the first board 131 is arranged in the heat dissipation case 140, the support blocks 1411 and the support protrusions 1412 may support the first board 131. Here, the support protrusions 1412 and the first board 131 may be fastened together by separate fastening elements, and the position of the first board 131 may be fixed to the heat dissipation case 140.

A plurality of the support protrusions 1412 may be provided and arranged along the circumference of the support blocks 1411. In some embodiments, the support protrusions 1412 may be arranged along each corner of the support blocks 1411. In some embodiments, the support protrusions 1412 may be arranged on opposite sides (the upper and lower sides or the left and right sides in FIG. 7) of the support blocks 1411.

However, the present disclosure is not limited thereto, and various modifications are possible, such as the support protrusions 1412 being arranged along the circumference of the first board 131, within the technical scope where the support protrusions 1412 may extend toward the internal space from the inner surface IS of the heat dissipation case 140 and fix the position of the first board 131.

The support protrusions 1412 may fix the position of the first board 131 to the heat dissipation case 140, and set a gap between the first board 131 and the support blocks 1411 such that the thermally conductive pads TP are pressed with a preset compression ratio.

That is, the support protrusions 1412 may be designed with a negative dimension, considering the compression ratio of the thermally conductive pads TP.

Furthermore, the support protrusions 1412 may serve as a stopper to prevent the thermally conductive pads TP from being excessively pressed beyond the preset compression ratio.

In some embodiments, when the support protrusions 1412 are arranged to surround the support blocks 1411, the thermally conductive pads TP may receive a pressing force in a direction toward the inner surface IS. Accordingly, the circuit board may be prevented from being bent or lifted up due to the thermally conductive pads TP expanding by its elastic restoring force, and the thermally conductive pads TP may be in close contact with the circuit board and the support blocks 1411 to efficiently transfer heat.

The second board 132 may be arranged on one side (the right side in FIG. 7) of the first board 131. The second board 132 may be supported by the sub-plate SP, which partitions the space inside the first body 141 and the second body 142.

Although not illustrated in the drawings, the second space S2 may be provided on a surface of the sub-plate SP opposite to the surface on which the second board 132 is arranged, and the third board 133 may be arranged in the second space S2. This will be described in detail below.

That is, the first board 131 and the second board 132 may be arranged in the first space S1, which is enclosed by the first body 141, the main plate MP, and the sub-plate SP. Here, the first board 131 may be arranged on the inner surface IS of the heat dissipation case 140, and in detail, may be supported by the support blocks 1411, which protrude from the inner surface IS, and may be fixed in position by the support protrusions 1412.

The second board 132 may be arranged on the sub-plate SP, which partitions an internal space of the heat dissipation case 140 into the first space S1 and the second space S2, and the third board 133 may be arranged in the second space S2, which is a space between the sub-plate SP and the second body 142. Accordingly, the second board 132 and the third board 133 may be stacked inside the heat dissipation case 140.

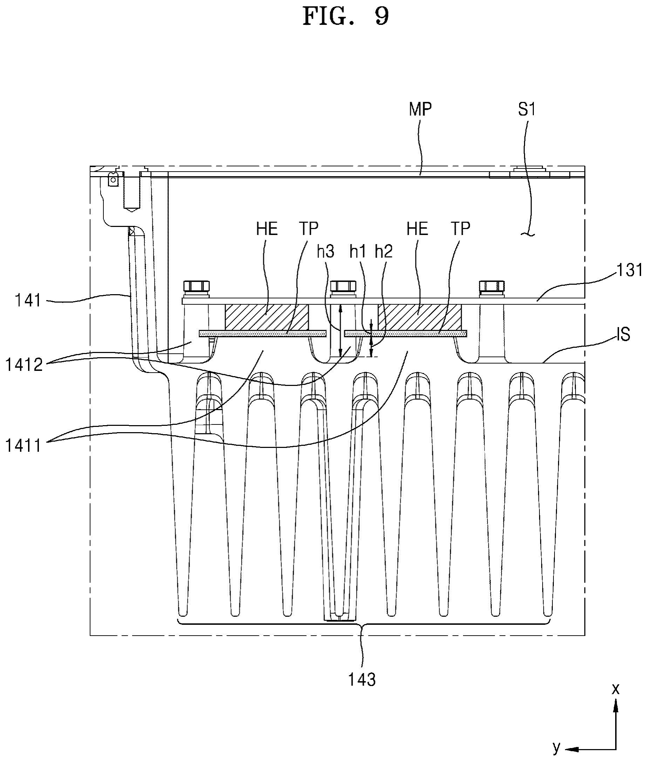

FIG. 8 is a cross-sectional view taken along line IV-IV' of FIG. 3, and FIG. 9 is an enlarged view of portion A of FIG. 8.

Referring to FIGS. 8 and 9, a plurality of circuit boards may be stacked in an internal space. In some embodiments, the first board 131 and the second board 132 may be arranged in the first space S1, which is a space enclosed by the first body 141, the main plate MP, and the sub-plate SP.

In some embodiments, the third board 133 may be arranged in the second space S2, which is a space enclosed by the second body 142 and the sub-plate SP. In this case, the second board 132 and the third board 133 may be arranged in an upper space and a lower space of the sub-plate SP, respectively.

The fourth board 134 may be arranged in the third space S3, which is enclosed by the main case 110 and the main plate MP. In this case, at least a part of the fourth board 134 may be covered by the safety cover 120. Accordingly, even when the door 112 is opened, only the safety cover 120 may be exposed to the outside, and the internal fourth board 134 may be protected.

In the inverter 100 according to an embodiment of the present disclosure, the internal space defined by the assembly of the main case 110 and the heat dissipation case 140 is partitioned into three spaces by arranging the main plate MP and the sub-plate SP therein, and the space utilization inside the inverter 100 is improved by arranging circuit boards in the respective spaces.

Furthermore, by arranging the first board 131, which includes a plurality of heating elements HE, on the inner surface IS of the first body 141, which has the support blocks 1411 on one side and the heat dissipation fins 143 on another side, heat generated from the heating elements HE may be efficiently transferred to the heat dissipation case 140 and then discharged to the outside.

The support blocks 1411 and the support protrusions 1412 may each have a height in a longitudinal direction (the x-axis direction in FIG. 8).

A height h1 of the support blocks 1411 may be less than a height h3 of the support protrusions 1412. Accordingly, when the position of the first board 131 is fixed inside the heat dissipation case 140 by the support protrusions 1412, a gap corresponding to the height difference between the support blocks 1411 and the support protrusions 1412 may be formed between the support blocks 1411 and the first board 131.

The thermally conductive pad TP may be arranged between the support block 1411 and the first board 131, to fill the gap between the two components. Because the thermally conductive pads TP transfer heat from the first board 131 to the support blocks 1411, heat dissipation performance may be improved.

The thermally conductive pad TP may have a height h2 that is less than the height h1 of the support blocks 1411. In this case, the thermally conductive pads TP may be compressed with a preset compression ratio as the support protrusions 1412 and the first board 131 are fastened together, to fill a gap between the first board 131 and the support blocks 1411.

In some embodiments, to compress the thermally conductive pads TP with a preset compression ratio, the height h3 of the support protrusions 1412 may be designed with a minus dimension.

When the thermally conductive pads TP are arranged between the first board 131 and the support blocks 1411, and the support protrusions 1412 fix the position of the first board 131, the height h3 of the support protrusions 1412 may be substantially the same as the sum of the height h1 of the support blocks 1411, the height h2 of the compressed thermally conductive pads TP, and the height of the heating elements HE.

The support blocks 1411 may be arranged on a side of the heat dissipation case opposite to the side on which the heat dissipation fin is arranged. In other words, on the surface of the first body 141 opposite to the inner surface IS that has the support blocks 1411, a plurality of heat dissipation fins 143 that extend outward may be formed. Accordingly, heat transferred to the heat dissipation case 140 through the thermally conductive pads TP and the support blocks 1411 may be immediately discharged to the outside through the heat dissipation fins 143.

In the heat dissipation case 140, the first board 131, the heating elements HE, the thermally conductive pads TP, the support blocks 1411, and the heat dissipation fins 143 may be arranged sequentially from top to bottom.

The heat dissipation case 140 may include a material having high thermal conductivity, for example, a metallic material such as aluminum or copper, and may efficiently dissipate heat generated in the internal space to the outside.

The heat dissipation case 140 may have the first body 141, the second body 142, and the heat dissipation fins 143. In this case, the first body 141, the second body 142, and the heat dissipation fins 143 may be integrally formed. In an alternative embodiment, the heat dissipation case 140 may be manufactured by a die-casting method.

Heat generated from the heating elements HE arranged on the first board 131 may be transferred to the support blocks 1411 via the thermally conductive pads TP, and the heat transferred to the support blocks 1411 may be discharged to the outside through the heat dissipation fins 143, which extend outward.

Here, the thermally conductive pads TP may be arranged between the support blocks 1411 and the first board 131 to transfer heat generated from the heating elements HE to the heat dissipation case 140.

Here, the thermally conductive pads TP may include a material having an elastic restoring force such that a thickness thereof is adjusted as necessary, and the thermally conductive pads TP may be in close contact with irregular surfaces of the first board 131 and the support blocks 1411 to minimize contact thermal resistance due to an air insulating layer and maximize heat transfer efficiency.

The support blocks 1411 may space the circuit board apart from the inner surface IS of the heat dissipation case 140 by a preset interval. Accordingly, the circuit board and the inner surface IS may be arranged to maintain a constant interval, and a sufficient insulation distance may be secured.

The inverter 100 according to an embodiment of the present disclosure has an effect in that an electrical short circuit may be prevented by primarily securing an insulation distance by physically spacing a circuit board and the heat dissipation case 140 apart, and secondarily by arranging the thermally conductive pads TP having insulating properties between the circuit board and the heat dissipation case 140.

The heat dissipation case 140 may have the second body 142 that is arranged adjacent to the heat dissipation fins 143 and has an internal space. Here, the internal space of the second body 142 may be the second space S2. The third board 133 may be arranged in the second body 142.

The second body 142 may have sub-support blocks 1421 that protrudes toward the internal space and on which a circuit board is arranged. Here, the circuit board supported by the sub-support blocks 1421 may be the third board 133.

A plurality of sub-support blocks 1421 may be arranged in the second body 142, and may be spaced apart from each other.

Thermally conductive pads TP may be arranged between the sub-support blocks 1421 and the circuit board. Accordingly, heat generated from the circuit board may be effectively transferred to the sub-support blocks 1421.

The second body 142 may further have a sub-support protrusion 1422, which extends toward and supports the circuit board. A plurality of sub-support protrusions 1422 may be provided and may be arranged along the circumference of the sub-support block 1421.

Heating elements HE may be arranged below the circuit board that is arranged in the second body 142. Thermally conductive pads TP may be arranged between the heating elements HE and the sub-support blocks 1421, and may contact the circuit board over an area larger than that of the heating elements HE.

The configurations of the sub-support blocks 1421, the sub-support protrusion 1422, and the third board 133 in the second body 142 are substantially the same as those of the support blocks 1411, the support protrusions 1412, and the first board 131 in the first body 141 in terms of operational effects and arrangement relationships, and thus, detailed descriptions thereof will be omitted.

Hereinafter, an operating principle and effects of the inverter 100 and the energy storage system 20 according to an embodiment of the present disclosure will be described.

The inverter 100 according to an embodiment of the present disclosure may include the main case 110, the safety cover 120, the circuit board unit 130, the heat dissipation case 140, the hood cover 150, the fixing member GM, and the support members SM.

Referring to FIG. 4, the circuit board unit 130 having at least one circuit board may be arranged in an internal space defined by the assembly of the main case 110 and the heat dissipation case 140. In this case, the main plate MP and the sub-plate SP may be stacked in the internal space to partition the internal space into the first space S1, the second space S2, and the third space S3.

Referring to FIGS. 7 to 9, the first board 131 and the second board 132 may be arranged in a space enclosed by the heat dissipation case 140, the main plate MP, and the sub-plate SP.

The first board 131 may be arranged on the support blocks 1411 and may be supported by a plurality of support blocks 1411. Heating elements HE may be arranged on a surface (the lower surface in FIG. 8) of the first board 131 on which the support blocks 1411 are provided. That is, the support blocks 1411 may be formed at positions corresponding to the positions of the heating elements HE.

Thermally conductive pads TP may be arranged between the first board 131, on which the heating elements HE are arranged, and the support blocks 1411. The thermally conductive pads TP, which fill a gap between the first board 131 and the support blocks 1411 and transfer heat generated from the heating elements HE to the heat dissipation case 140, may include a material having an elastic restoring force.

In this case, the cross-sectional area of the thermally conductive pad TP may be larger than the cross-sectional areas of the support blocks 1411 and the heating elements HE. Accordingly, an electrical short circuit, which may occur due to the first board 131 directly contacting the heat dissipation case 140, may be prevented.

In some embodiments, the support blocks 1411 have a preset height and may space the first board 131 apart from the inner surface IS by the height h1 of the support blocks 1411. Accordingly, an insulation distance corresponding to the height h1 of the support blocks 1411 may be secured between the first board 131 and the heat dissipation case 140.

Referring to FIG. 9, the support blocks 1411 may be arranged on a side opposite to the heat dissipation fins 143. In other words, the heat dissipation fins 143 and the support blocks 1411 may be arranged on opposite sides of the inner surface IS, respectively. Accordingly, heat transferred to the support blocks 1411 through the thermally conductive pads TP may be easily discharged to the outside by the heat dissipation fins 143.

That is, the circuit board, the heating elements HE, the thermally conductive pads TP, the support blocks 1411, and the heat dissipation fins 143 may be arranged in the first direction, and heat generated by the heating elements HE may be transferred through the corresponding path to be easily discharged to the outside.

Referring to FIG. 7, the heat dissipation case 140 may have the support protrusions 1412 that extend toward the circuit board. The support protrusions 1412 may be fastened to the circuit board to set the position of the circuit board. Here, the circuit board may receive a pressing force in a direction toward the inner surface IS of the heat dissipation case 140.

The support protrusions 1412 may be arranged adjacent to the support blocks 1411, and a plurality of support protrusions 1412 may be provided and arranged to surround the support blocks 1411. Accordingly, the support protrusions 1412 may apply a force to the circuit board at positions adjacent to the support blocks 1411, and the circuit board may be prevented from being bent or lifted from the support blocks 1411 due to the elastic restoring force of the thermally conductive pads TP.

However, the present disclosure is not limited thereto, and the support protrusions 1412 may be arranged along an inner circumferential surface of the heat dissipation case 140, and various arrangements are possible within the technical scope where the circuit board and the heat dissipation case 140 may be connected to each other.

Referring to FIG. 8, the heat dissipation case 140 may be arranged adjacent to the heat dissipation fins 143 and may further have an internal space. The sub-plate SP may be arranged between the second body 142 and the first body 141 to partition the space into the first space S1 and the second space S2.

The second space S2 is a space enclosed by the second body 142 and the sub-plate SP, and the third board 133 may be arranged in the second space S2. Here, the second board 132 may be arranged on the sub-plate SP and may be supported by the sub-plate SP.

The second body 142 may have the sub-support blocks 1421 protruding toward the third board 133 and the sub-support protrusions 1422 extending in the same direction as the sub-support blocks 1421.

Thermally conductive pads TP may be arranged between the sub-support blocks 1421 and the third board 133, and heat generated from the heating elements HE arranged on the third board 133 may be transferred through the thermally conductive pads TP and the sub-support blocks 1421 to be discharged to the outside of the heat dissipation case 140.

The sub-support protrusion 1422 is connected to the third board 133, and a plurality of the sub-support protrusions 1422 may be provided in the second body 142. In some embodiments, the plurality of sub-support protrusions 1422 may be arranged to surround the sub-support blocks 1421. The sub-support protrusions 1422, like the support protrusions 1412, may apply a force to the third board 133 in a direction toward the second body 142, and accordingly, the third board 133 may be brought into close contact with the sub-support blocks 1421 and the thermally conductive pads TP.

In the inverter 100 according to an embodiment of the present disclosure, because the thermally conductive pads TP are arranged between the support blocks 1411 inside the heat dissipation case 140 and the circuit board arranged on the support blocks 1411, there is an effect that heat generated from the circuit board may be easily discharged to the outside.

Furthermore, a plurality of support protrusions 1412 arranged to surround the support blocks 1411 cause the circuit board and the thermally conductive pads TP to come into close contact with the support blocks 1411, thereby increasing thermal conduction efficiency.

Although an embodiment of the present disclosure has been described above, the spirit of the present disclosure is not limited to the embodiment presented in the present specification, and those skilled in the art who understand the spirit of the present disclosure may easily suggest other embodiments by adding, modifying, or removing components within the same scope of the spirit, but these embodiments will also fall within the scope of the spirit of the present disclosure.

## Claims

1. An inverter comprising:
a main case;
a heat dissipation case that covers one side of the main case and has a plurality of heat dissipation fins; and
a circuit board unit arranged in an internal space defined by an assembly of the main case and the heat dissipation case, the circuit board unit having at least one circuit board configured to mutually convert between direct current power and alternating current power,
wherein the heat dissipation case comprises a support block protruding toward the internal space and on which the circuit board is arranged.

2. The inverter of claim 1, further comprising a thermally conductive pad arranged between the support block and the circuit board.

3. The inverter of claim 2, wherein the thermally conductive pad has an elastic restoring force.

4. The inverter of claim 2, wherein the thermally conductive pad has a height that is less than a height of the support block.

5. The inverter of claim 2, further comprising a heating element arranged below the circuit board,
wherein the thermally conductive pad is arranged between the heating element and the support block.

6. The inverter of claim 2, wherein the thermally conductive pad is in contact with the support block, and
a total area of the thermally conductive pad is greater than a contact area between the thermally conductive pad and the support block.

7. The inverter of claim 1, wherein the heat dissipation case further comprises a support protrusion extending toward the circuit board and supporting the circuit board.

8. The inverter of claim 7, wherein the support protrusion is provided as a plurality of support protrusions arranged along a circumference of the support block.

9. The inverter of claim 1, wherein the support block is arranged on a side of the heat dissipation case opposite to the side on which the heat dissipation fin is arranged.

10. The inverter of claim 1, wherein the support block spaces the circuit board apart from an inner surface of the heat dissipation case by a preset interval.

11. An energy storage system comprising:
an inverter; and
a storage device,
wherein the inverter comprises:
a main case;
a heat dissipation case that covers one side of the main case and has a plurality of heat dissipation fins; and
a circuit board unit arranged in an internal space defined by an assembly of the main case and the heat dissipation case, the circuit board unit having at least one circuit board configured to mutually convert between direct current power and alternating current power,
the heat dissipation case comprises a support block which protrudes toward the internal space and on which the circuit board is arranged, and
the inverter and the storage device are electrically connected to each other.

12. The energy storage system of claim 11, further comprising a thermally conductive pad arranged between the support block and the circuit board.

13. The energy storage system of claim 12, further comprising a heating element arranged below the circuit board,
wherein the thermally conductive pad is arranged between the heating element and the support block.

14. The energy storage system of claim 11, wherein the heat dissipation case further comprises a support protrusion extending toward the circuit board and supporting the circuit board.

15. The energy storage system of claim 11, wherein the support block is arranged on a side of the heat dissipation case opposite to the side on which the heat dissipation fin is arranged.
